Europäisches Patentamt

European Patent Office

Office européen des brevets

(19)

(11) Numéro de publication: **0 322 961 B1**

(12) **FASCICULE DE BREVET EUROPEEN**

(45) Date de publication de fascicule du brevet: **10.06.92**

(51) Int. Cl.⁵: **H01L 29/72**, H01L 21/90

(21) Numéro de dépôt: **88202928.3**

(22) Date de dépôt: **19.12.88**

(54) **Procédé de réalisation d'un transistor bipolaire à hétérojonction.**

(30) Priorité: **30.12.87 FR 8718391**

(43) Date de publication de la demande:
**05.07.89 Bulletin 89/27**

(45) Mention de la délivrance du brevet:
**10.06.92 Bulletin 92/24**

(84) Etats contractants désignés:
**DE FR GB NL**

(56) Documents cités:
**EP-A- 0 184 016**

**PATENT ABSTRACTS OF JAPAN, vol. 12, no. 89 (E-592)[2936], 23 mars 1988, page 108 E 592; & JP-A-62 224 073**

**INTERNATIONAL ELECTRON DEVICES MEETING, Washington, DC, 1-4 décembre 1985, IEDM Technical Digest, pages 328-331, IEEE, New York, US; T. IZAWA et al.: "AlGaAs/GaAs heterojunction bipolar transistors"**

(73) Titulaire: **LABORATOIRES D'ELECTRONIOUE PHILIPS
3, Avenue Descartes
F-94450 Limeil-Brévannes(FR)**

(84) Etats contractants désignés:
**FR**

(73) Titulaire: **N.V. Philips' Gloeilampenfabrieken
Groenewoudseweg 1
NL-5621 BA Eindhoven(NL)**

(84) Etats contractants désignés:
**DE GB NL**

(72) Inventeur: **Selle, Daniel Société Civile S.P.I.D.
209, rue de l'Université
F-75007 Paris(FR)**
Inventeur: **Boissenot, Daniel Société Civile S.P.I.D.
209, rue de l'Université
F-75007 Paris(FR)**
Inventeur: **Rabinzohn, Patrick Société Civile S.P.I.D.
209, rue de l'Université
F-75007 Paris(FR)**

GaAs IC SYMPOSIUM - TECHNICAL DIGEST 1985, Monterey, California, 12-14 novembre 1985, pages 53-56, IEEE, New York, US; T. OHSHIMA et al.: "A self-aligned GaAs/AlGaAs heterojunction bipolar transistor with V-groove isolated planar structure"

IEEE ELECTRON DEVICE LETTERS, vol. EDL-7, no. 1, janvier 1986, pages 8-10, IEEE, New York, US; M.F. CHANG et al.: "GaAs/(GaAl)As heterojunction bipolar transistors using a self-aligned substitutional emitter process"

APPLIED PHYSICS LETTERS, vol. 49, no. 19, 10 novembre 1986, pages 1278-1280, American Institute of Physics, New York, US; K. TAIRA et al.: "Emitter grading in AlGaAs/GaAs heterojunction bipolar transistor grown by metalorganic chemical vapor deposition"

IBM TECHNICAL DISCLOSURE BULLETIN, vol. 23, no. 12, mai 1981, pages 5380-5383, IBM Corp., New York, US; C.G. JAMBOTKAR: "High-speed, high-density bipolar technology"

(74) Mandataire: **Landousy, Christian et al Société Civile S.P.I.D. 156, Boulevard Haussmann F-75008 Paris(FR)**

## Description

L'invention concerne un procédé de réalisation d'un dispositif semiconducteur du type transistor bipolaire à hétérojonction à structure planaire, ce procédé comprenant au moins la réalisation d'une structure comportant successivement au moins une couche de collecteur en un matériau binaire d'un premier type de conductivité, une couche de base en un matériau binaire du second type de conductivité opposé au premier, une couche d'émetteur en un matériau ternaire du premier type de conductivité et une couche binaire de contact fortement dopée du premier type de conductivité.

L'invention trouve son application dans la réalisation de circuits intégrés sur matériaux du groupe III-V et notamment sur arséniure de gallium, incluant des transistors bipolaires à hétérojonction.

Un transistor bipolaire à hétérojonction, de structure planaire, est déjà connu de la publication intitulée "A Fully Planar-Heterojunction Bipolar Transistor" par John W. TULLY et alii dans "IEEE Electron Device Letters, Vol.EDL 7 n°11, Nov.1986", pp.615-617.

Ce document décrit un transistor formé sur un substrat semiconducteur de type de conductivité $n^+$. Ce transistor comprend une première couche de GaAs de type $n^+$, une seconde couche de GaAs de type $n$ et une couche de base de type $p^+$ formée par implantation localisée, dans la partie supérieure de la couche de GaAs de type $n$.

Ce transistor comprend ensuite deux couches supérieures, la première en GaAlAs de type $n$ pour former l'émetteur et la seconde en GaAs de type $n^+$ pour permettre la prise des contacts. Les régions de base sont constituées par des caissons $p^+$ reliant les contacts de base à la couche implantée $p^+$.

Le procédé de réalisation de ce transistor commence par la croissance épitaxiale des couches collecteur $n^+$ et $n$ par la méthode dite MOCVD. La région de base est définie par un masque en photorésist et est implantée sélectivement au moyen d'ions $Zn^+$. Après élimination de la couche de photorésist le substrat est réinséré dans le réacteur MOCVD pour un recuit à haute température. Cette opération est suivie immédiatement par la croissance de la couche d'émetteur de type $n$ en GaAlAs et la couche de contact de type $n^+$ en GaAs. La couche d'émetteur de composition $Ga_{1-x}Al_xAs$ montre un gradient de la concentration $x$ en Al. Dans les premiers 50 nm la concentration $x$ est comprise entre 0 et 0,30. Puis le reste de la couche émetteur est réalisé avec $x = 0,30$ en Al. A la suite le dispositif est couvert de $SiO_2$ puis d'une couche d'Al, d'une épaisseur de chacune 400 nm. Les contacts de base sont définis par photolithographie et l'aluminium est gravé chimiquement, puis la couche de $SiO_2$ est gravée par plasma. Ce procédé résulte en une gravure de $SiO_2$ plus importante que celle de Al, lequel fait une saillie au-dessus de $SiO_2$. Ce procédé sert ultérieurement au LIFT-OFF de l'aluminium. La couche supérieure de GaAs est ainsi découverte et des ions $Zn^+$ sont implantés dans les ouvertures de $Al/SiO_2$. Puis, un métal apte à former un contact de type $p$ tel que Mo/Cr est évaporé.A ce point du procédé, l'aluminium est éliminé chimiquement, ce qui permet d'éliminer l'excès de Mo/Cr. Après le LIFT-OFF, l'échantillon est recuit à haute température pour activer l'implantation $p^+$. Enfin, les contacts d'émetteur et de collecteur définis par photolithographie, sont réalisés simultanément au moyen d'un métallisation de AuGe/Ni/Au, le métal en excès est éliminé et ses contacts sont recuits.

Dans ce procédé connu, les métallisations d'émetteur et de collecteur sont "simplement alignées" par rapport à la métallisation de base. Ce type d'alignement conduit à une précision difficilement meilleure que le micron. Il en résulte que les espacements entre les métallisations d'émetteur et de base, et les espacements entre les métallisations de collecteur et de base sont au moins égaux au micron. Dans ces conditions les transistors présentent des dimensions trop importantes pour être compatibles avec les performances recherchées pour l'application envisagée.

Au contraire, la présente invention propose un procédé de réalisation qui permet d'obtenir un "autoalignement" des contacts d'émetteur et de collecteur sur les contacts de base, d'où il résulte la possibilité de réaliser :
- un émetteur de dimension submicronique,
- des intervalles entre électrodes extrêmement petits et de dimensions extrêmement précises.

Ces avantages sont dus au fait que le procédé selon l'invention met en oeuvre, pour la définition des régions de base, un procédé de gravure extrêmement précis, qui permet d'autoaligner toutes les électrodes sur les contacts de base, en se fondant sur cette opération fondamentale que constitue cette gravure contrôlée.

Il en résulte que les transistors obtenus selon l'invention :
- sont extrêmement compacts, donc de très petites dimensions et permettent une intégration à haute densité,
- montrent des dimensions très répétitives d'un transistor à l'autre et donc une très faible dispersion de leur cactéristiques.

Ce but est atteint au moyen d'un procédé tel que décrit dans le préambule et qui comprend en outre les étapes :
- a/ dépôt d'une couche de germanium (Ge), suivi du dépôt d'une couche de silice ($SiO_2$) ;

b/ mise en place d'un masque MK$_2$ délimitant les ouvertures en surplomb des régions de contact de base et gravure de la couche de silice à travers ces ouvertures jusqu'à mettre à nu la surface de la couche de germanium par une méthode permettant d'obtenir des flancs de gravure perpendiculaires au plan des couches, formant ainsi, dans la couche de silice, des ouvertures ;

c/ gravure de la couche de germanium à travers les ouvertures de la couche de silice, par une méthode permettant de contrôler à la fois, sur les flancs de gravure de cette couche de germanium, le taux de gravure parallèlement au plan des couches et le taux de gravure perpendiculairement au plan des couches, de manière telle que les pieds de ces flancs de gravure délimitent des ouvertures de dimension au moins égale à la dimension des ouvertures de la couche de silice, et que les sommets de ces flancs de gravure délimitent avec une très haute précision des ouvertures telles que la distance dans le germanium du bord d'une ouverture au bord de l'ouverture suivante définit la région d'émetteur et de manière telle que ces flancs de gravure présentent une concavité tournée vers l'extérieur du dispositif ;

d/ implantation localisée d'ions du second type de conductivité à travers les ouvertures, et avec une énergie suffisant à atteindre la couche de base, pour former des caissons du second type de conductivité reliant la couche de base à la surface de la couche de contact ;

e/ dépôt d'une couche métallique propre à former les contacts de base, suivi de la gravure sélective de la couche de silice, conservant intacts les plots de la couche de germanium ;

f/ réalisation d'une nouvelle couche de silice SiO$_2$, très épaisse, planarisation du dispositif au niveau supérieur de la couche de germanium, puis gravure sélective des plots de la couche de germanium par une méthode permettant de conserver avec une grande précision en négatif le profil des flancs de gravure définis au cours de l'étape c/ le long des plots de la nouvelle couche de silice restant sur l'emplacement des ouvertures définis au cours de l'étape b/, ces plots de silice délimitant par leur partie supérieure des ouvertures de dimension égale à la distance dans le germanium du bord d'une ouverture au bord de l'ouverture suivante définis au cours de de l'étape c/ ;

g/ dépôt d'une couche métallique propre à former les contacts d'émetteur et de collecteur, les plots de la nouvelle couche de silice servant de masque, puis élimination des plots de la nouvelle couche de silice ;

h/ implantation localisée entre les contacts de collecteur, base, et émetteur servant de masques, d'éléments propres à former des caissons isolants entre ces électrodes et avec une énergie permettant d'atteindre la surface supérieure de la couche d'émetteur du premier type de conductivité.

L'invention sera mieux comprise au moyen de la description suivante illustrée par les figures annexées dont :

- la figure 1a qui représente en coupe schématique le transistor bipolaire à hétérojonction planaire obtenu par le procédé selon l'invention,
- la figure 1b qui représente ce transistor vu du dessus,
- les figures 2a à 2i qui illustrent les différentes étapes du procédé de réalisation selon l'invention,
- la figure 3 qui montre le profil de gravure de la couche de germanium sous la couche de silice lors de la définition des zones de base et d'émetteur par le procédé selon l'invention,
- la figure 4 qui illustre des étapes formant une variante du procédé.

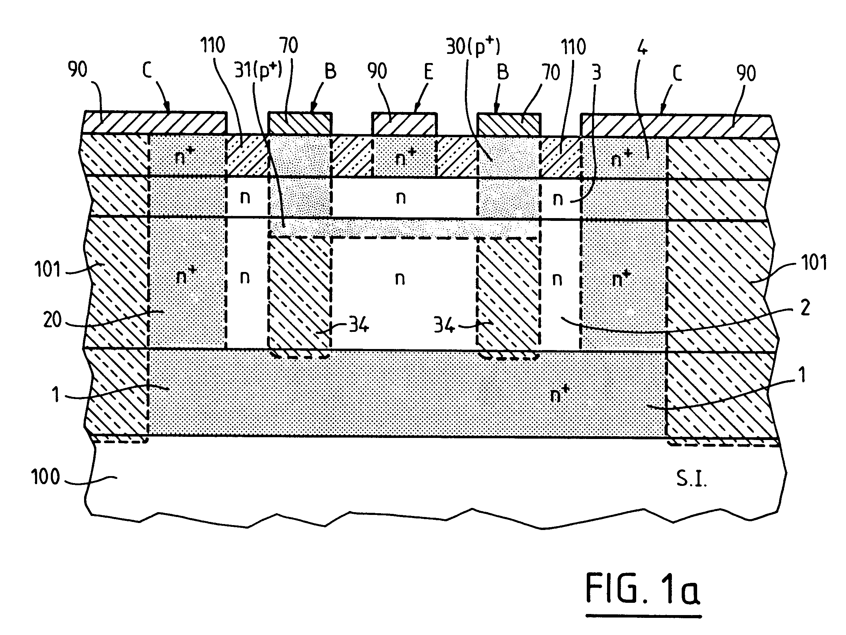

Tel que représenté sur la figure 1a, le dispositif selon l'invention comprend d'abord, réalisée sur un substrat semi-isolant 100 en un matériau du groupe III-V, une couche 1 en arséniure de gallium (GaAs) de type de conductivité n$^+$.

Ce transistor comprend ensuite une couche 2 d'arséniure de gallium (GaAs) de type de conductivité n.

Ce transistor comprend en outre une couche 3 d'arséniure de gallium et d'aluminium (GaAlAs) de type de conductivité n, ou couche émetteur.

En surface de la couche 3 on trouve, pour permettre la prise des contacts collecteurs et émetteurs, une couche épitaxiale 4 d'arséniure de gallium (GaAs) de type de conductivité n$^+$. Cette couche 4 de type n$^+$ est reliée à la couche collecteur 1 de type n$^+$, par des caissons 20 de type n$^+$, disposés sous les contacts collecteurs C$_1$.

En surface de la couche 4 sont réalisés les contacts métalliques de collecteur C, de base B et d'émetteur E.

Formés dans les couches 3 et 4, on trouve sous les contacts de base B, des caissons 30 de type de conductivité p$^+$ reliés par une couche 31 réalisée au niveau de la surface de la couche 2 également de type de conductivité p$^+$.

Le contact de base est réalisé au moyen de métaux tels que AuMn ou AuBe. Les contacts d'émetteur et de collecteur au moyen de métaux tels que : AuGe/Ni.

L'isolation entre les différentes électrodes est obtenue au moyen de caissons 110.

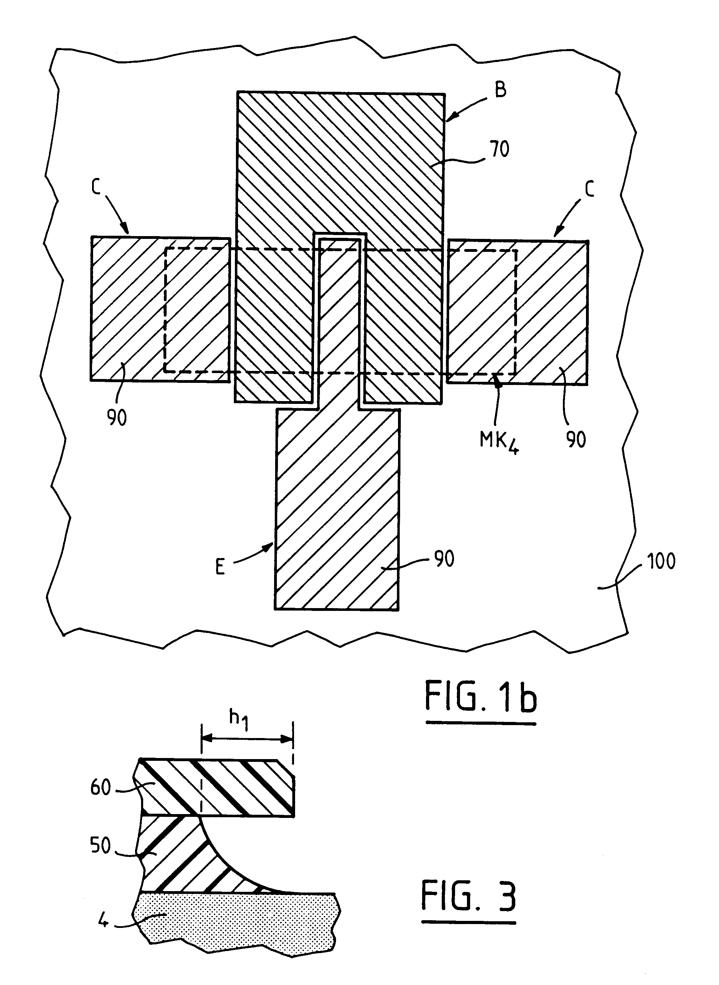

Ce transistor présente l'avantage d'être absolument planaire. Comme illustré par la figure 1b, vu du dessus, il montre en outre une structure interdigitée, à deux doigts de base B, et un doigt d'émetteur E. Il montre aussi un contact de collecteur C.

Le procédé de réalisation décrit ci-après montre comment obtenir un tel transistor dont les contacts d'émetteur et de collecteur sont autoalignés sur les contacts de base, ce qui permet d'obtenir des dimensions transverses extrêmement faibles, précises et répétitives et donc des transistors de très faibles dimensions et dont les performances sont améliorées. Ce qui fait que la densité d'intégration peut être augmentée et que les performances des circuits sont aussi améliorées. Le procédé de réalisation selon l'invention comprend au moins les étapes suivantes :

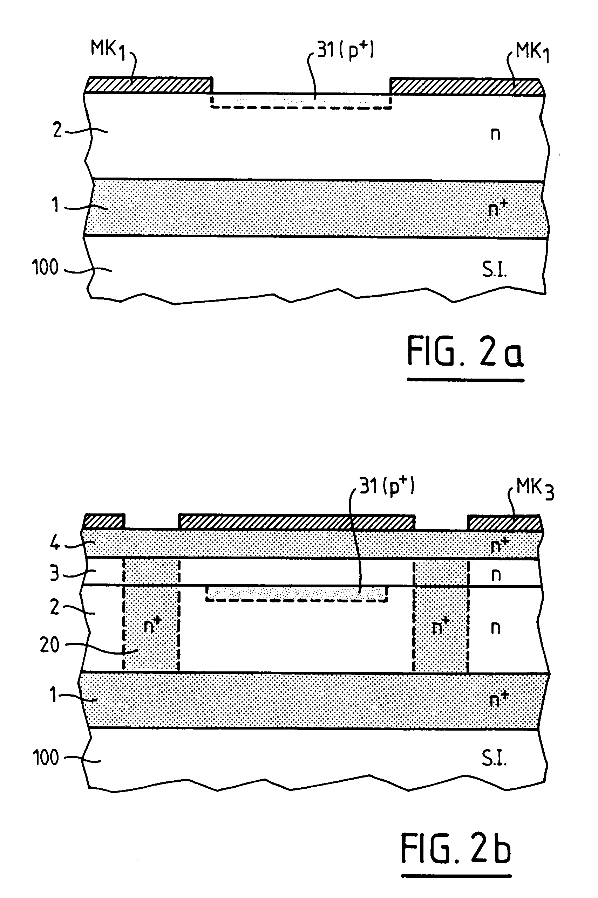

a/ formation d'un substrat 100 en un matériau du groupe III-V monocristallin présentant une face supérieureorientée par exemple selon une direction cristallographique [1 0 0]. Ce substrat est choisi semi-isolant pour que le procédé se trouve en synergie de fabrication avec les procédés de réalisation de circuits intégrés. En effet, le but visé par l'invention est la réalisation de transistors à hétérojonction intégrés et non pas la réalisation de transistors discrets. Le substrat sera favorablement en arséniure de gallium GaAs, semi-isolant obtenu par exemple par dopage au moyen d'ions fer (Fe). Ce substrat pourra aussi être réalisé en arséniure de gallium dopé à l'indium et recuit, ce qui permet d'obtenir des matériaux dépourvus de dislocations et compatibles avec la croissance ultérieure de couches épitaxiales du groupe III-V,

b/ réalisation de deux couches épitaxiales planes d'arséniure de gallium pour former le collecteur, successivement une couche 1 de type de conductivité $n^+$ et une couche 2 de type de conductivité n. La croissance épitaxiale de ces couches peut être réalisée en phase vapeur ou en phase liquide. Elle sera réalisée de préférence par une méthode aux organo-métalliques (MOCVD) ou MBE. La couche 1 présentera une épaisseur de 0,2 à 1 $\mu$m et de préférence 0,5 $\mu$m. Cette couche 1 est de type de conductivité $n^+$ obtenue par exemple par un dopage au moyen de l'ion silicium (Si) à environ 3 à 5. $10^{18}$ ions par cm³ (voir la figure 2a). L'épaisseur optimale de la couche 2 est 0,3 $\mu$m et le type de conductivité n est obtenu par exemple par dopage au moyen de l'ion silicium (Si) à $5.10^{16}$ ions par cm³ ;

c/ implantation localisée dans la région superficielle de la seconde couche collecteur 2 de porteurs de type p pour former une couche de base 31 de type de conductivité $p^+$ (voir la figure 2a). A cet effet un masque MK$_1$ par exemple en photorésist est réalisé en surface de la couche 2 et une ouverture est pratiquée dans ce masque en surface de la région destinée à constituer la région de base. La couche 31 est réalisée par l'implantation peu profonde (100 nanomètres et moins) d'ions tels que Be, ou Mg ou Zn. On peut également réaliser une co-implantation de phosphore P avec Be, ou bien de fluor F avec Mg, ce qui permet d'améliorer le pourcentage d'activation, et de réduire la diffusion lors de traitements thermiques ultérieurs. La concentration des ions implantés sera environ $5.10^{18}$ cm$^{-3}$ ;

d/ réalisation de deux couches épitaxiales planes superposées, la première 3 d'un matériau ternaire du groupe III-V, par exemple de l'arséniure de gallium et d'aluminium(GaAlAs), de type de conductivité n formant la couche d'émetteur, et la seconde 4 d'un matériau binaire ou ternaire, par exemple GaAs ou GaInAs de type de conductivité $n^+$ pour permettre la prise des contacts. La croissance épitaxiale de ces couches sera réalisée par le même procédé choisi pour la croissance des couches 1 et 2 (voir figure 2b). La couche d'émetteur 3 aura une épaisseur de l'ordre de 0,15 $\mu$m et la couche de contact 4 aura une épaisseur de l'ordre de 0,15 $\mu$m. La couche d'émetteur 3 sera dopée à l'aide d'ions par exemple Si à une concentration de l'ordre de $5.10^{17}$ par cm³ et la couche de contact 4 à l'aide d'ions Si à une concentration de $2.10^{18}$ par cm³. La couche 3 en arséniure de gallium et d'aluminium (GaAlAs) présentera de préférence une concentration de 0,25 en aluminium ;

e/ implantation localisée, dans une région choisie pour former le collecteur, de porteurs de type n à une profondeur appropriée à réaliser des caissons 20 de type $n^+$ reliant la couche 1 d'arséniure de gallium de collecteur de type $n^+$ à la couche 4 d'arséniure de gallium de type $n^+$. Cette implantation sera faite dans l'ouverture d'un masque MK$_3$, à l'aide d'ions par exemple Si, à une concentration de l'ordre de $5.10^{18}$ par cm³. A l'issue de cette implantation le masque MK$_3$ sera éliminé (voir la figure 2b).

Pour obtenir le profil plat à $5.10^{18}$ souhaité, on procédera au moyen d'énergies décroissantes.

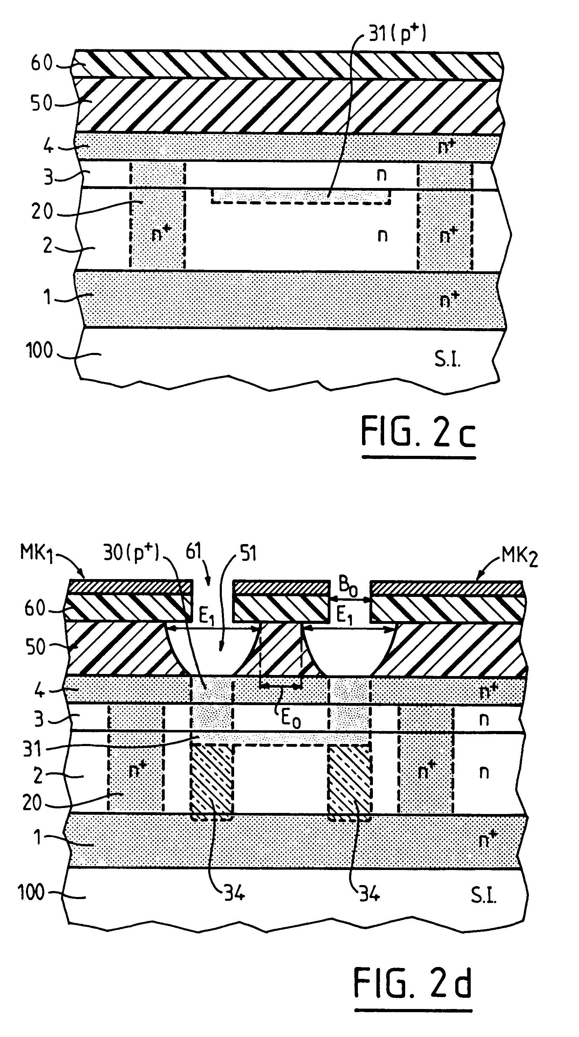

f/ dépôt d'une couche 50 de germanium Ge, suivi du dépôt d'une couche 60 de silice (SiO$_2$). Ces dépôts sont réalisés par dépôt chimique en phase vapeur assisté par plasma (PECVD). La couche de germanium présente favorablement une épaisseur de 0,4 $\mu$m et la couche de silice une épaisseur de 0,6 $\mu$m (voir la figure 2c) ;

g/ mise en place d'un masque MK$_2$ par exemple en photorésist, délimitant des ouvertures 61 en surplomb des régions de base, et gravure de la couche de silice 60 à travers ces ouvertures 61 jusqu'à mettre à nu la surface de la couche de germanium 50. Cette gravure est mise en oeuvre par une méthode permettant d'obtenir des flancs de gravure perpendiculaires au plan des couches par exemple par gravure ionique réactive (RIE) au moyen des gaz $CHF_3$ - $SF_6$ (dans le rapport 30 à 1). On forme ainsi des ouvertures dans la couche 60 (voir la figure 2d), ouvertures qui ont pour dimension $B_0$ dans le plan de la figure 2d et délimitent les futures régions de base ;

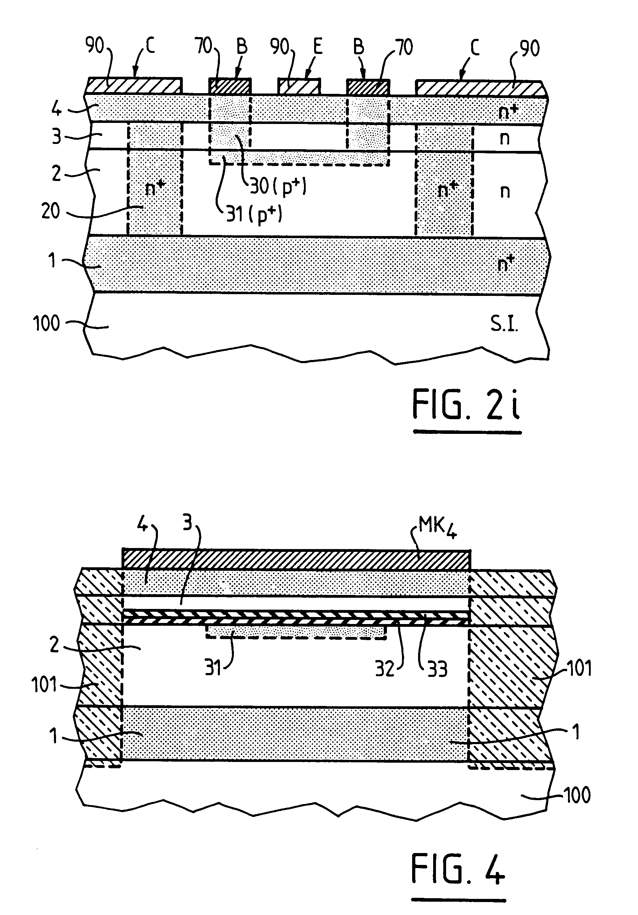

h/ gravure de la couche de germanium 50 à travers les ouvertures $B_0$ de la couche de silice, par une méthode permettant de contrôler à la fois, sur les flancs de gravure de cette couche de germanium, le taux de gravure parallèlement au plan des couches, et le taux de gravure perpendiculairement au plan des couches, de manière à obtenir que les pieds de ces flancs de gravure délimitent des ouvertures de dimension au moins égale à $B_0$ et que les sommets de ces flancs délimitent avec une très haute précision des ouvertures $E_1$ telles que la distance $E_0$ dans le germanium du bord d'une ouverture $E_1$ au bord de l'ouverture $E_1$ suivante définit la région d'émetteur (voir la figure 3). L'élaboration de ce profil doit être très bien contrôlée car elle va permettre en une seule opération de définir à la fois les contacts de base et le contact d'émetteur, selon une technologie dite autoalignée.

Comme représenté sur la figure 3, il apparaît une gravure du germanium sous la couche de silice qui est légèrement concave, la concavité étant tournée vers l'extérieur du dispositif. Le taux de gravure parallèlement au plan du substrat doit être de l'ordre de :

160 nm par min et le taux de gravure perpendiculairement au plan du substrat 325 nm par min.

Ceci est obtenu par gravure ionique réactive (RIE) au moyen d'un mélange de gaz $SF_6$ à 12,5 SCCM, $O_2$ à 4 SCCM et $N_2$ à 13,5 SCCM avec une pression et une puissance respectivement de 4 Pa (30 millitorrs) et 60 watts. Dans ces conditions la gravure parallèlement au plan des couches est moitié de la gravure perpendiculairement au plan des couches ; la dimension de la gravure du germanium sous la couche de silice est $h_1$ ;

i/ implantation localisée de porteurs de type $p^+$ à travers les ouvertures $B_0$ avec une énergie suffisante à atteindre la couche de base 31, pour former des caissons 30 de type $p^+$, reliant la couche de base 31 à la surface de la couche épitaxiale 4 de type $n^+$. Cette implantation est faite comme lors de l'étape c/ au moyen d'ions Mg ou Be, ou Zn, ou de la co-implantation déjà citée. Un profil d'implantation plat est obtenu au moyen d'intensités décroissantes, jusqu'à obtenir une concentration de quelques $10^{19}$ $cm^{-3}$.

Le recuit d'implantation peut être fait à 850°C pendant quelques min à 10 min sous pression d'arsine ($AsH_3$). Mais de préférence le recuit sera du type "FLASH" pour minimiser les phénomènes de diffusion et améliorer l'activation, consistant à porter le dispositif à 900°C pendant 3 secondes par exemple (voir la figure 2d) ;

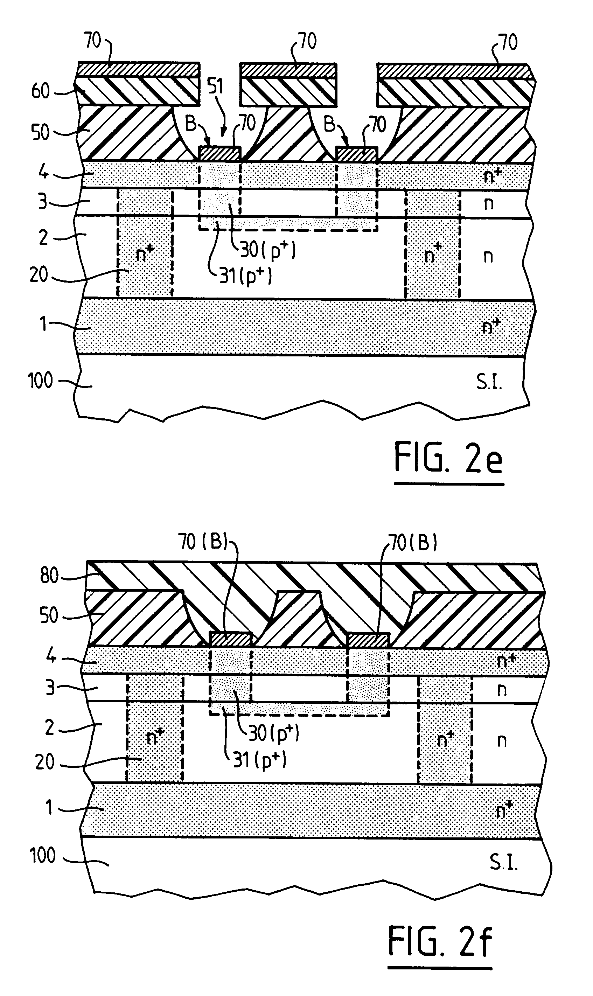

j/ dépôt dans les ouvertures $B_0$ d'une couche métallique 70 propre à former les contacts de base B, suivi de la gravure sélective de la couche de silice 60 conservant intacts des plots de la couche de germanium 50 (voir figure 2e). La couche métallique 70 pourra être favorablement composée d'or-manganèse (Au-Mn), d'or-béryllium (Au-Be), d'or-zinc (Au-Zn), ce sera de préférence Au-Mn à 4 %, qui permet d'obtenir un contact de faible résistivité. Cette couche se dépose non seulement dans les ouvertures $B_0$ mais encore en surface de la silice 60. La gravure ultérieure de la couche de silice 60 permettra d'éliminer par LIFT-OFF les portions de la couche 70 indésirables. La gravure de la couche de silice 60 se fera au moyen d'une solution d'acide fluorhydrique (HF) tamponnée, pour permettre d'éliminer la couche de silice 60 sans endommager les contacts de base B formés dans les ouvertures $B_0$ ;

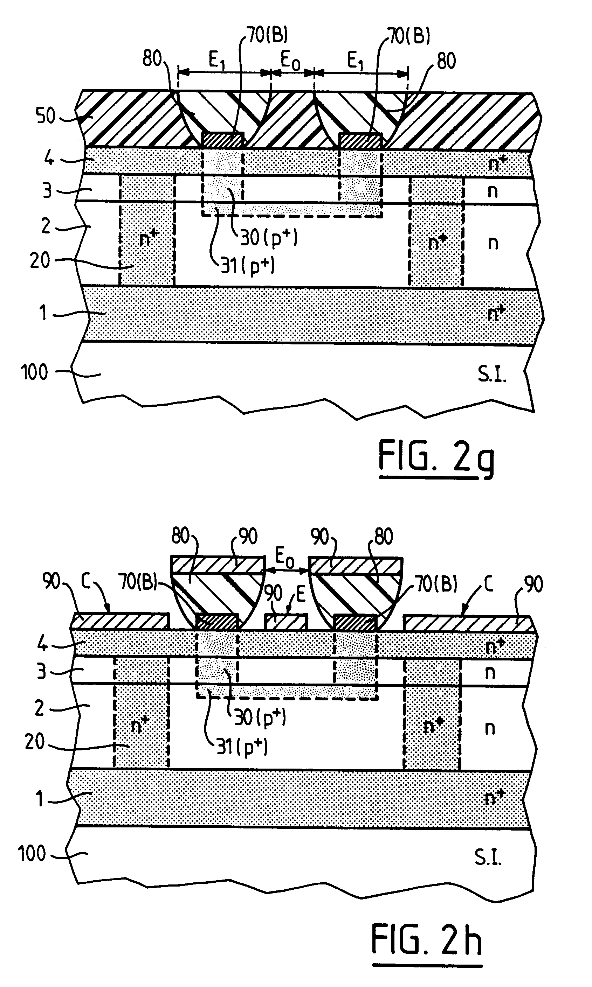

k/ réalisation d'une nouvelle couche 80 de silice (voir la figure 2f), puis planarisation du dispositif au niveau supérieur de la couche de germanium, (voir la figure 2g), suivi d'une gravure sélective des plots de la couche de germanium 50 par une méthode permettant de conserver avec une grande précision, en négatif, le profil des flancs de gravure défini au cours de l'étape h/ le long des plots de la nouvelle couche de silice 80 restant sur l'emplacement des ouvertures 51 (voir la figure 2h).

Les sommets de ces plots 80 qui ont la dimension des anciennes ouvertures $E_1$ définissent notamment des ouvertures $E_0$ délimitant le futur contact d'émetteur. Les sommets de ces plots 80 qui sont en surplomb sur la couche 4 permettront aussi de définir les contacts de collecteur par auto-alignement, ce surplomb définissant l'espacement entre les électrodes.

Lors de la réalisation de la nouvelle couche épaisse 80 de silice ($SiO_2$) les ouvertures 51 sont emplies de silice. Puis le procédé de planarisation est entrepris. Sur la mise en oeuvre d'un tel procédé, on lira avec profit la publication : "1984 5-MIC Conference June 21-22" 1984 IEEE intitulée : "Plasma Planarisation with a non-planar sacrificial layer" par J.E.Gimpelson et alii p.37-44, ou encore "Journal Electrochemical Society Solid State Science and Technology, January 1986" l'article intitulé : "Two layer planarisation process" par A.

SHILZ et alii p.178-181. Ici la planarisation peut être menée à bien par gravure RIE au moyen des gaz CHF$_3$-O$_2$, avec 30 SCCM pour CHF$_3$ et 3 SCCM pour O$_2$. A l'issue de ce procédé il reste le dispositif tel que montré sur la figure 2g où la silice 80 emplit les ouvertures 51 et est au même niveau supérieur que la couche de germanium 50. Les plots de silice 80 ont alors le même profil en négatif que les plots de germanium 50 obtenus lors de l'étape h/. Comme on l'a dit précédemment, ce profil doit être conservé lors de la gravure du germanium 50. C'est pourquoi cette gravure se fera par exemple par gravure ionique réactive (RIE) effectuée au moyen de gaz SF$_6$-N$_2$ (50 % - 50 %).

l/ dépôt d'une couche métallique 90 propre à former les contacts d'émetteur E et de collecteur C, les plots de la nouvelle couche de silice 80 servant de masque, puis élimination des plots de la nouvelle couche de silice 80.

Le métal pour constituer la couche 90 de contact d'émetteur et de collecteur sera avantageusement une multicouches de l'alliage Au-Ge surmonté d'une couche de nickel (voir la figure 2h). Les contacts subissent un recuit à environ 400°C.

Lors du dépôt, la couche métallique 90 a aussi couvert les plots de silice 80 ; cette partie de la couche 90 indésirable sera éliminée par LIFT-OFF lors de l'élimination de la silice, par exemple au moyen d'une solution d'HF. tamponnée.

On obtient alors le dispositif du transistor à hétérojonction de la forme planar recherchée (voir la figure 2i). De plus ce dispositif a été obtenu par l'autoalignement des contacts collecteur-émetteur sur les contacts de base en une seule opération consistant en l'obtention du profil des flancs de gravure de la couche de germanium 50, puis la conservation en négatif de ce profil sur les plots de silice 80.

m/ implantation ionique localisée entre les contacts de collecteur C, de base B et d'émetteur E servant de masque, d'espèces propres à former des caissons isolants 110 entre ces électrodes pour éviter les courants de fuite, avec une énergie permettant d'atteindre la surface supérieure de la couche 3 d'émetteur de type n. On pourra à cet effet implanter des ions bore (B), oxygène (O), ou bien implanter des protons à une concentration d'environ $2.10^{18}$ cm$^{-3}$.

Ainsi le dispositif selon l'invention présente différents avantages : tout d'abord l'utilisation d'un substrat semi-isolant en arséniure de gallium permet de se trouver en synergie de réalisation avec d'autres dispositifs tels que les transistors à effet de champ, les diodes etc..., l'utilisation du substrat SI permet d'éliminer les capacités parasites des plots de contacts.

Dans une variante de l'invention le substrat semi-isolant est en arséniure de gallium et d'indium, qui est obtenu directement semi-isolant par recuit, et qui est particulièrement exempt de dislocations comme il est connu de la demande de brevet européen EP-A-0176130.

D'autre part dans cette variante, la couche 1 du collecteur peut être réalisée par implantation ionique par exemple de sélénium (Se) directement dans le substrat semi-isolant 100.

On notera que le fait de réaliser les doigts d'émetteur très étroits permet d'améliorer les performances du dispositif. En effet, le schéma équivalent du transistor HBT montre une résistance en série avec la base et une capacité base-collecteur.

La réponse en fréquence du transistor est déterminée par le produit de la résistance de base par la capacité base-collecteur. La réduction des dimensions du transistor permet de réduire le produit de ces deux facteurs, et par conséquent d'augmenter la réponse en fréquence du transistor. Il s'ensuit que ce dernier montre alors des performances réellement et nettement améliorées par rapport au dispositif connu de l'art antérieur.

Le procédé selon l'invention peut en outre comprendre une étape d'isolation pour délimiter le transistor. A cet effet, une étape d$'$) peut être intercalée entre l'étape d et l'étape e.

d$'$) Implantation d'ions favorablement 0$^+$ dans les ouvertures d'un masque MK$_4$ qui couvre la zone active du transistor à l'exception de la périphérie (voir la figure 4). Les ions sont implantés dans les zones périphériques 101 d'isolement du transistor.

Il est déjà connu de l'état de la technique d'implanter des ions bore (B) pour réaliser l'isolation des zones actives. Ce type d'implantation au bore crée des défauts et permet d'isoler par exemple des couches de type n et p, ce qui est nécessaire lorsque la couche de base est réalisée par épitaxie sur toute la surface du dispositif et n'est pas localisée comme ici, selon l'invention à une couche 31 parfaitement délimitée.

Ici, l'isolation à l'aide d'oxygène est choisie de préférence à l'isolation au bore du fait que, si cette dernière était choisie, son efficacité disparaîtrait lors de recuits à des températures supérieures à 500-600°C. Or de tels recuits supérieurs à 600°C sont utilisés ultérieurement dans le présent procédé.

Ainsi l'isolation au bore n'étant pas nécessaire puisque la couche de base est délimitée par une méthode autre que l'isolation après épitaxie, l'isolation à l'oxygène est au contraire favorable.

Le procédé selon l'invention peut en outre comprendre la réalisation d'une couche destinée à éviter la diffusion des porteurs p de la couche de base 31 vers la couche émetteur 3. A cet effet, ce procédé comprend alors entre l'étape c/ et l'étape d/, une étape c$'$/ telle que :

c'/ Réalisation d'une couche épitaxiale 32 en surface de la couche 2, en GaAs, non dopée intentionnellement ou faiblement dopée p, de l'ordre de 10 à 20 nm pour éviter la diffusion des porteurs p de la couche 31 vers la couche 3 (voir la figure 4).

Le procédé selon l'invention peut aussi comprendre une étape c″/ entre l'étape c'/ et l'étape d/ telle que :

c″/ Réalisation d'une couche épitaxiale 33 en GaAlAs présentant un gradient de composition en Al de 0 à 25 % de façon à obtenir une hétérojonction graduelle entre l'émetteur et la base, ce qui permet d'obtenir un meilleur gain en courant (voir la figure 4).

Le procédé selon l'invention peut aussi comprendre entre l'étape h/ et l'étape i/ une étape h'/ telle que :

h'/ Implantation à travers les ouvertures $B_0$ d'ions oxygène pour créer des zones d'isolement 34 sous les zones de base extrinsèques et ainsi réduire la capacité base-collecteur, permettant alors d'améliorer la réponse en fréquence du transistor. La concentration favorable en oxygène implanté sera de $5.10^{16}$ cm$^{-3}$ à $5.10^{18}$ cm$^{-3}$. La profondeur d'implantation sera dans la zone entre la couche 31 et la couche 1 (voir la figure 2d).

La figure 1b représente vu du dessus un exemple de réalisation du dispositif. La ligne en trait discontinu représente les bords du masque $MK_4$ qui couvrait la zone active durant l'étape d'/ et qui délimite de ce fait cette zone active.

D'autres formes du transistor sont possibles et notamment de nombreuses autres configurations des électrodes sans sortir du cadre de la présente invention.

Enfin au lieu de réaliser l'isolation de la zone active lors de l'étape d'/, cette isolation peut être réalisée lors d'une ultime étape m'/ par implantation de protons ou bore, autour d'un masque couvrant la zone active du transistor.

Des valeurs préférentielles pour les différentes dimensions mises en oeuvre dans le procédé selon l'invention sont données ci-après :

$B_0 = 1$ à $2\ \mu$m
$E_1 = 0,9$ à $1,6\ \mu$m
$h_1 = 0,2$ à $0,3\ \mu$m
$E_0 = 0,5$ à $1\ \mu$m

On peut aussi réaliser la couche de base dans une variante de l'invention en remplaçant l'étape c/, connue de l'état de la technique, par une étape $c_0$/ telle que :

$c_0$/ Réalisation d'une couche épitaxiale 31' en un matériau binaire du groupe III-V de type de conductivité p$^+$ pour former une couche de base, suivie d'une gravure, autour d'un masque définissant la zone de base, jusqu'au niveau supérieur de la couche collecteur 2. La gravure peut être faite par voie sèche ou humide. La zone de base 31' se trouve alors en relief sur la couche collecteur 2. Le procédé est repris comme précédemment. L'épaisseur de la couche p$^+$ 31' est de l'ordre de 0,1 $\mu$m. Le dispositif obtenu est donc quasi-planaire.

D'autres matériaux III-V peuvent être envisagés pour réaliser le transistor, pourvu que les conditions nécessaires à l'obtention des hétérojonctions soient respectées.

**Revendications**

1. Procédé de réalisation d'un dispositif semiconducteur du type transistor bipolaire à hétérojonction à structure planaire, ce procédé comprenant au moins la réalisation d'une structure comportant successivement au moins une couche de collecteur (1, 2) en un matériau binaire d'un premier type de conductivité, une couche de base (31) en un matériau binaire du second type de conductivité opposé au premier, une couche d'émetteur (3) en un matériau ternaire du premier type de conductivité, une couche binaire de contact (4) fortement dopée du premier type de conductivité et des caissons (20) du premier type du conductivité reliant la couche de collecteur à la couche de contact, caractérisé en ce qu'il comprend en outre les étapes de :

    a/ dépôt d'une couche (50) de germanium (Ge), suivi du dépôt d'une couche (60) de silice (SiO$_2$) ;

    b/ mise en place d'un masque (MK$_2$) délimitant des ouvertures (61) en surplomb des régions de contact de base et gravure de la couche de silice à travers ces ouvertures jusqu'à mettre à nu la surface de la couche de germanium par une méthode permettant d'obtenir des flancs de gravure perpendiculaires au plan des couches, formant ainsi, dans la couche de silice, des ouvertures (B$_0$);

    c/ gravure de la couche de germanium à travers les ouvertures de la couche de silice, par une méthode permettant de contrôler à la fois, sur les flancs de gravure de cette couche de germanium, le taux de gravure parallèlement au plan des couches et le taux de gravure perpendiculairement au plan des couches, de manière telle que les pieds de ces flancs de gravure délimitent des ouvertures de dimension au moins égales à la dimension des ouvertures (B$_0$) de la couche de silice et que les sommets de ces flancs de gravure délimitent avec une très haute précision des ouvertures (E$_1$) telles

que la distance ($E_0$) dans le germanium du bord d'une ouverture au bord de l'ouverture suivante définit la région d'émetteur, et de manière telle que ces flancs de gravure présentent une concavité tournée vers l'extérieur du dispositif ;

d/ implantation localisée d'ions du second type de conductivité à travers les ouvertures, et avec une énergie suffisante à atteindre la couche de base, pour former des caissons (30) du second type de conductivité reliant la couche de base à la surface de la couche de contact ;

e/ dépôt d'une couche métallique (70) propre à former les contacts de base (B), suivi de la gravure sélective de la couche de silice, conservant intacts des plots de la couche de germanium ;

f/ réalisation d'une nouvelle couche (80) de silice ($SiO_2$), très épaisse, planarisation du dispositif au niveau supérieur de la couche de germanium, puis gravure sélective des plots de la couche de germanium par une méthode permettant de conserver avec une grande précision en négatif le profil des flancs de gravure définis au cours de l'étape c/ le long des plots de la nouvelle couche de silice restant sur l'emplacement des ouvertures définis au cours de l'étape b/, ces plots de silice délimitant, par leur partie supérieure, des ouvertures de dimension égale à la distance dans le germanium du bord d'une ouverture au bord de l'ouverture suivante définis au court de l'étape c/ ;

g/ dépôt d'une couche métallique (90) propre à former les contacts d'émetteur (E) et de collecteur (C), les plots de la nouvelle couche de silice servant de masque, puis élimination des plots de la nouvelle couche de silice ;

h/ implantation localisée entre les contacts de collecteur, base, et émetteur servant de masques, d'éléments propres à former des caissons isolants (110) entre ces électrodes et avec une énergie permettant d'atteindre la surface supérieure de la couche d'émetteur du premier type de conductivité.

2. Procédé selon la revendication 1, caractérisé en ce que la structure des couches de collecteur de base et d'émetteur est formée sur un substrat semi-isolant, et en ce que dans cette structure :

- le collecteur est constitué par la superposition de deux couches binaires (1, 2) du premier type de conductivité dont la première (1) est fortement dopée ;
- la couche de base (31) est réalisée par une implantation localisée d'ions du second type de conductivité dans la région superficielle de la seconde couche collecteur (2);

- des caissons (20) reliant la première couche de collecteur à la couche de contact (4) sont réalisés par une implantation localisée, dans une région choisie pour former le collecteur, d'ions du premier type de conductivité.

3. Procédé selon la revendication 1 ou 2, caractérisé en ce que le transistor est isolé par une implantation d'ions propres à former des régions d'isolement (101) délimitant la zone active du transistor, cette dernière étant masquée durant cette opération.

4. Procédé selon l'une des revendications précédentes, caractérisé en ce qu'entre la couche binaire de base (31) et la couche ternaire d'émetteur (3), une couche binaire (32), non dopée intentionnellement est réalisée pour éviter la diffusion des porteurs de la couche binaire de base vers la couche ternaire d'émetteur.

5. Procédé selon la revendication 4, caractérisé en ce qu'entre la couche binaire (32) non dopée intentionnellement et la couche ternaire d'émetteur (3) on réalise une couche ternaire (33) présentant un gradient de composition pour obtenir une hétérojonction graduelle entre l'émetteur et la base.

6. Procédé selon l'une des revendications précédentes, caractérisé en ce qu'entre l'étape c) et l'étape d), il comprend une étape c') telle que :

c') implantation dans les ouvertures ($B_0$) d'ions propres à créer des zones d'isolement (34) sous les régions de contact de base (30, 31).

7. Procédé selon l'une des revendications 2 à 5, caractérisé en ce que :

- le substrat (100) est en arséniure de gallium (GaAs) semi-isolant orienté selon une direction cristallographique [100] ;
- les couches binaires sont en arséniure de gallium (GaAs) ;
- les couches ternaires sont en arséniure de gallium et d'aluminium (GaAlAs), présentant éventuellement un gradient de composition de l'élément Al lorsque ce gradient est prévu ;
- le premier type de conductivité est le type n ;
- le second type de conductivité opposé est le type p.

**8.** Procédé selon la revendication 7, caractérisé en ce que, pour obtenir le type de conductivité $n^+$ ou $n$ les couches sont dopées à l'aide d'ions $Si^+$.

**9.** Procédé selon l'une des revendications 7 ou 8, caractérisé en ce que pour obtenir des caissons de type de conductivité $n^+$, l'implantation ionique prévue est réalisée au moyen d'ions $Si^+$.

**10.** Procédé selon l'une des revendications précédentes, caractérisé en ce que pour obtenir des zones de type de conductivité $p^+$, l'implantation ionique prévue est réalisée au moyen d'ions choisis parmi Be, Mg, Zn, et parmi une association de F avec Be, ou P avec Mg.

**11.** Procédé selon l'une des revendications précédentes, caractérisé en ce que la couche métallique (70) déposée lors de l'étape e) pour former les contacts de base est choisie parmi les composés Au-Mn, Au-Be, Au-Zn, et en ce que la couche métallique (90) déposée lors de l'étape g) pour former les contacts d'émetteur et collecteur est une multicouche d'Au-Ge surmontée de Ni.

**12.** Procédé selon l'une des revendications 3 ou 6, caractérisé en ce que pour former les zones isolantes (101, 34), il est implanté des ions oxygène $(0^+)$.

**13.** Procédé selon l'une des revendications précédentes, caractérisé en ce que pour former les zones isolantes (110) entre les électrodes, lors de l'étape h), il est implanté des éléments choisis parmi des ions B, des ions $0^+$, et des protons.

**14.** Procédé selon l'une des revendications précédentes, caractérisé en ce que la couche de base est une couche additionnelle en un matériau binaire du groupe III-V du second type de conductivité avec une gravure, autour d'un masque définissant la zone de base, jusqu'au niveau supérieur de la couche collecteur.

**Claims**

**1.** A method of manufacturing a semiconductor device of the heterojunction bipolar transistor type having a planar structure, this method comprising at least the realization of a structure comprising successively at least a collector layer (1, 2) of a binary material of a first conductivity type, a base layer (31) of a binary material of a second conductivity type opposed to the first, an emitter layer (3) of ternary material of the first conductivity type, a highly doped binary contact layer (4) of the first conductivity type, and islands (20) of the first conductivity type connecting the collector layer to the contact layer, characterized in that it comprises in addition the steps of:

a/ depositing a layer (50) of germanium (Ge) and subsequently depositing a layer (60) of silica ($SiO_2$);

b/ positioning a mask ($MK_2$) defining openings (61) perpendicular to the base contact regions and etching the silica layer through said openings until the surface of the germanium layer is exposed by a method which permits of obtaining etching flanks perpendicular to the plane of the layers, thus forming openings $B_0$ in the silica layer;

c/ etching the germanium layer (50) through the openings of the silica layer by a method which permits of controlling on the etching flanks of said germanium layer both the etching rate parallel to the plane of the layers and the etching rate perpendicular to the plane of the layer in such a manner that the feet of these etching flanks define openings having a dimension at least equal to the dimension of the openings ($B_0$) in the silica layer and that the tops of these etching flanks define openings ($E_1$) with a very high precision such that the distance ($E_0$) in the germanium from the edge of one opening to the edge of the next opening defines the emitter region and in such a manner that these etching flanks have a concavity facing towards the exterior of the device;

d/ localized implantation of ions of the second conductivity type the openings with an energy sufficient to attain the base layer in order to form islands (30) of the second conductivity type connecting the base layer to the surface of the contact layer;

e/ depositing a metal layer (70) suitable to form the base contacts (B), followed by selective etching of the silica layer, leaving intact the pads of the germanium layer;

f/ forming a fresh, very thick layer (80) of silica ($SIO_2$), planarizing the device at the upper level of the germanium layer and then selectively etching the pads of the germanium layer by a method which permits of maintaining with a high precision in negative the profile of the etching flanks defined during the step c/ along the pads of the fresh silica layer remaining at the area of the openings defined during the step b/, these silica pads defining by their upper part openings having a dimension equal to the distance in the germanium from the edge of one opening to the edge of the next opening as defined during the step c/;

g/ depositing a metal layer (90) suitable to form the emitter (E) and collector (C) contacts, the pads of the fresh silica layer serving as a mask, and then eliminating the pads of the fresh silica layer;

h/ localized ion implantation between the collector, base and emitter contacts, which serve as a mask, of elements suitable to form insulating islands (110) between these electrodes with an energy which permits of attaining the upper surface of the emitter layer of the first conductivity type.

2. A method as claimed in Claim 1, characterized in that the structure of the collector, base and emitter layers is formed on a semi-insulating substrate and in that in said structure:
   - the collector is formed by the superposition of two binary layers (1, 2) of the first conductivity type, of which the first (1) is highly doped;
   - the base layer (31) is realized by a localized implantation of ions of the second conductivity type into the surface region of the second collector layer (2);
   - islands (20) connecting the first collector layer to the contact layer (4) are realized by a localized implantation, into a regions chosen to form the collector, of ions of the first conductivity type.

3. A method as claimed in Claim 1 or 2, characterized in that the transistor is insulated by an implantation of ions suitable for forming insulation regions (101) defining the active zone of the transistor, the latter zone being masked during this operation.

4. A method as claimed in any one of the preceding Claims, characterized in that a not intentionally doped binary layer (32) is provided between the binary base layer (31) and the ternary emitter layer (34) in order to prevent the diffusion of carriers from the binary base layer to the ternary emitter layer.

5. A method as claimed in Claim 4, characterized in that a ternary layer (33) having a composition gradient is provided between the not intentionally doped binary layer (32) and the ternary emitter layer (3) so as to obtain a gradual heterojunction between the emitter and the base.

6. A method as claimed in any one of the preceding Claims, characterized in that between the step c/ and the step d/ a step c'/ is included, i.e.:

   c'/ implantation through the openings ($B_0$) of ions suitable for producing insulation zones (34) under the base contact zones (30, 31).

7. A method as claimed in any one of Claims 2 to 5, characterized in that:
   - the substrate (100) consists of semi-insulating gallium arsenide (GaAs) orientated in a crystallographic direction [100],
   - the binary layers consists of gallium arsenide (GaAs),
   - the ternary layers consists of gallium-aluminium arsenide (GaAlAs), possibly having a gradient in its content of the element Al if such a gradient is envisaged;
   - the first conductivity type is the n type;
   - the second, opposed conductivity type is the p-type.

8. A method as claimed in Claim 7, characterized in that, in order to obtain the $n^+$ or n conductivity type, the layers are doped by means of $Si^+$ ions.

9. A method as claimed in any one of Claim 7 or 8, characterized in that, in order to obtain islands of the $n^+$ conductivity type, the ion implantation provided is effected by means of $Si^+$ ions.

10. A method as claimed in any one of the preceding Claims, characterized in that, in order to obtain zones of the $p^+$ conductivity type, the ion implantation provided is effected by means of ions chosen from among Be, Mg and Zn and from among an association of F with Be, or of P with Mg.

11. A method as claimed in any one of the preceding Claims, characterized in that the metal layer (70) deposited during the step e/ for forming the base contacts is chosen from among the compounds Au-Mn, Au-Be and Au-Zn, and in that the metal layer (90) deposited during the step g/ for forming the emitter and collector contacts is a multi-layer of Au-Ge with Ni disposed thereon.

12. A method as claimed in Claim 3 or 6, characterized in that oxygen ($O^+$) ions are implanted for forming the insulation zones (101, 34).

**13.** A method as claimed in any one of the preceding Claims characterized in that elements chosen from among B ions, $O^+$ ions and protons are implanted in order to form the insulation zones (110) between the electrodes during the step h/.

**14.** A method as claimed in any one of the preceding Claims, characterized in that the base layer is an additional layer of a binary material from the III-V group of the second conductivity type etches around a mask defining the base zone down to a level which is higher than the collector layer.

**Patentansprüche**

**1.** Verfahren zur Herstellung einer Halbleiteranordnung vom Typ des bipolaren Heteroübergangsplanartransistors, wobei dieses Verfahren mindestens die Realisierung einer Struktur enthält, die nacheinander mindestens eine Kollektorschicht (1,2) aus einem binären Material eines ersten Leitfähigkeitstyps, eine Basisschicht (31) aus einem binären Material des zweiten, dem ersten entgegengesetzten Leitfähigkeitstyps, eine Emitterschicht (3) aus einem ternären Material des ersten Leitfähigkeitstyps, eine hoch dotierte binäre Kontaktschicht (4) des ersten Leitfähigkeitstyps und die Kollektorschicht mit der Kontaktschicht verbindende Inseln (20) des ersten Leitfähigkeitstyps aufweist, dadurch gekennzeichnet, daß es außerdem die Schritte:
a/ Deposition einer Germaniumschicht (Ge) (50), gefolgt von der Deposition einer Siliciumdioxidschicht (SiO$_2$) (60), umfaßt, sowie
b/ Plazieren einer Maske (MK$_2$), die die Öffnungen (61) im Überhang der Basiskontaktbereiche abgrenzt, und Ätzen der Siliciumdioxidschicht quer durch diese Öffnungen, bis die Oberfläche der Germaniumschicht freigelegt ist, mittels eines Verfahrens, mit dem senkrecht zur Ebene der Schichten liegende Ätzkanten erhalten werden können, wodurch in der Siliciumdioxidschicht die Öffnungen (B$_0$) geformt werden,
c/ Ätzen der Germaniumschicht quer durch die Öffnungen der Siliciumdioxidschicht, mittels eines Verfahrens, mit dem, an den Ätzkanten dieser Germaniumschicht, gleichzeitig die Ätzrate parallel zur Ebene der Schichten und die Ätzrate senkrecht zur Ebene der Schichten gesteuert werden kann, so daß die Füße dieser Ätzkanten die Öffnungen aufeine Abmessung begrenzen, die mindestens gleich der Abmessung der Öffnungen (B$_0$) der Siliciumdioxidschicht ist, und daß die Kappen dieser Ätzkanten die Öffnungen (E$_1$) mit sehr hoher Präzision begrenzen, so daß der Abstand (E$_0$) in dem Germanium vom Rand einer Öffnung bis zum Rand der folgenden Öffnung das Emittergebiet definiert, und zwar so, daß diese Ätzkanten eine zum Äußeren der Anordnung gewandte Konkavität aufweisen;
d/ lokale Ionenimplantation des zweiten Leitfähigkeitstyps quer durch die Öffnungen und mit genügender Energie, um die Basisschicht zu erreichen, um Inseln (30) des zweiten Leitfähigkeitstyps zu bilden, die die Basisschicht mit der Oberfläche der Kontaktschicht verbinden;
e/ Deposition einer Metallschicht (70) zur Bildung der Basiskontakte (B) mit anschließendem selektiven Ätzen der Siliciumdioxidschicht, wobei die Kontaktflecke der Germaniumschicht unbeschädigt bleiben;
f/ Realisierung einer neuen, sehr dicken Siliciumdioxidschicht (80), Planarisierung der Anordnung bis auf die obere Ebene der Germaniumschicht, anschließend selektives Ätzen der Kontaktflecke der Germaniumschicht mittels eines Verfahrens, mit dem das in Schritt c/ definierte negative Profil der Ätzkanten entlang den Kontaktflecken der neuen Siliciumdioxidschicht, die am Ort der in Schritt b/ definierten Öffnungen erhalten geblieben sind, mit großer Genauigkeit bewahrt werden kann, wobei diese Siliciumdioxidflecke durch ihren oberen Teil Öffnungen begrenzen, die die gleiche Abmessung haben wie der Abstand im Germanium vom Rand einer Öffnung bis zum Rand der folgenden Öffnung, wie in Schritt c/ definiert;
g/ Deposition einer zur Bildung der Emitterkontakte (E) und der Kollektorkontakte (C) geeigneten Metallschicht (90), wobei die Kontaktflecke der neuen Siliciumdioxidschicht als Maske dienen, und anschließend Entfernung der Kontaktflecke der neuen Siliciumdioxidschicht;
h/ lokale Implantation zwischen den als Masken dienenden Kollektor-, Basis- und Emitterkontakten von zur Bildung von isolierenden Inseln (110) zwischen den Elektroden geeigneten Elementen mit einer Energie, die es erlaubt, die obere Fläche der Emitterschicht des ersten Leitfähigkeitstyps zu erreichen.

**2.** Verfahren nach Anspruch 1, dadurch gekennzeichnet, daß die Struktur der Kollektor-, Basis- und Emitterschichten aufeinem halbleitenden Substrat erzeugt wird, und daß in dieser Struktur:
- der Kollektor durch Überlagerung der beiden binären Schichten (1,2) des ersten Leitfähigkeitstyps gebildet ist, wobei die erste (1) der Schichten hoch dotiert ist;

- die Basisschicht (31) durch eine lokale Implantation von Ionen des zweiten Leitfähigkeitstyps in dem Oberflächenbereich der zweiten Kollektorschicht (2) erhalten wurde;
- Inseln (20), die die erste Kollektorschicht mit der Kontaktschicht (4) verbinden, durch einen lokale Implantation von Ionen des ersten Leifähigkeitstyps in einem für die Bildung des Kollektors ausgewählten Gebietes erhalten wurden.

3. Verfahren nach Anspruch 1 oder 2, dadurch gekennzeichnet, daß der Transistor durch eine Implantation von Ionen, die zur Bildung von Isolationsgebiete (101), die die aktive Zone des Transistors begrenzen, geeignet sind, isoliert wurde, wobei letztere während dieses Vorgangs abgedeckt ist.

4. Verfahren nach einem der vorhergehenden Ansprüche, dadurch gekennzeichnet, daß zwischen der binären Basisschicht (31) und der ternären Emitterschicht (3) eine absichtlich nicht dotierte binäre Schicht (32) realisiert ist, um die Diffusion von Ladungsträgern aus der binären Basisschicht zur ternären Emitterschicht zu verhindern.

5. Verfahren nach Anspruch 4, dadurch gekennzeichnet, daß zwischen der absichtlich nicht dotierten binären Schicht (32) und der ternären Emitterschicht (3) eine ternäre Schicht (33) realisiert wird, die einen Gradienten der Zusammensetzung aufweist, um einen graduellen Heteroübergang zwischen dem Emitter und der Basis zu erhalten.

6. Verfahren nach einem der vorhergehenden Ansprüche, dadurch gekennzeichnet, daß es zwischen dem Schritt c/ und dem Schritt d/ einen Schritt c'/ enthält, mit:

c'/ Implantation von zur Erzeugung von Isolationszonen (34) unter den Basiskontaktgebieten (30,31) geeigneten Ionen in den Öffnungen ($B_0$).

7. Verfahren nach einem der Ansprüche 2 bis 5, dadurch gekennzeichnet, daß :

- das Substrat (100) aus halbleitendem Galliumarsenid (GaAs) ist, das in einer kristallographischen Richtung [100] ausgerichtet ist;
- die binären Schichten aus Galliumarsenid (GaAs) sind;
- die ternären Schichten aus Galliumaluminiumarsenid (GaAlAs) sind, gegebenenfalls mit einen Gradienten der Zusammensetzung für das Element Al, wenn dieser Gradient vorgesehen ist;
- der erste Leitfähigkeitstyp der n-Typ ist;
- der zweite entgegengesetzte Leitfähigkeitstyp der p-Typ ist.

8. Verfahren nach Anspruch 7, dadurch gekennzeichnet, daß die Schichten mit den Ionen $Si^+$ dotiert sind, um den Leitfähigkeitstyp $n^+$ oder $n$ zu erhalten.

9. Verfahren nach einem der Ansprüche 7 oder 8, dadurch gekennzeichnet, daß die vorgesehene Ionenimplantation mit den Ionen $Si^+$ realisiert ist, um Inseln des Leitfähigkeitstyps $n^+$ zu erhalten.

10. Verfahren nach einem der vorhergehenden Ansprüche, dadurch gekennzeichnet, daß die vorgesehene Ionenimplantation mit Ionen aus Be, Mg, oder Zn und aus einer Assoziation von F mit Be oder P mit Mg realisiert ist, um Zonen des Leitfähigkeitstyps $p^+$ zu erhalten.

11. Verfahren nach einem der vorhergehenden Ansprüche, dadurch gekennzeichnet, daß die nach Schritt e/ zur Bildung der Basiskontakte deponierte Metallschicht (70) aus den Verbindungen Au-Mn, Au-Be, Au-Zn gewählt ist, und daß die nach Schritt g/ zur Bildung der Emitter- und Kollektorkontakte deponierte Metallschicht (90) eine Mehrlagenschicht aus mit Ni versehenem Au-Ge ist.

12. Verfahren nach einem der Ansprüche 3 oder 6, dadurch gekennzeichnet, daß zur Bildung der Isolationszonen (101, 34) Sauerstoffionen ($O^+$) implantiert sind.

13. Verfahren nach einem der vorhergehenden Ansprüche, dadurch gekennzeichnet, daß zur Bildung der Isolationszonen (110) zwischen den Elektroden nach Schritt h/ Elemente aus Ionen B, Ionen $O^+$ oder Protonen implantiert sind.

14. Verfahren nach einem der vorhergehenden Ansprüche, dadurch gekennzeichnet, daß die Basisschicht eine zusätzliche Schicht aus einem binären Material der Gruppe III-V des zweiten Leitfähigkeitstyps ist, mit einer Ätzung, um eine die Basiszone definierende Maske herum, bis auf die obere Ebene der Kollektorschicht.

FIG. 1a

EP 0 322 961 B1

14

B

70

C

C

90

MK₄

90

90

E

100

## FIG. 1b

$h_1$

60

50

4

## FIG. 3

MK$_1$     31 (p$^+$)     MK$_1$

2

n

1

n$^+$

100

S.I.

## FIG. 2a

31 (p$^+$)     MK$_3$

4     n$^+$

3     n

2     n$^+$     n$^+$     n

20

1     n$^+$

100     S.I.

## FIG. 2b

16

FIG. 2c

FIG. 2d

## FIG. 2e

## FIG. 2f

FIG. 2g

FIG. 2h

FIG. 2 i

FIG. 4